# EUROPÄISCHE PATENTSCHRIFT

(11) **EP 1 301 063 B1**
(45) Veröffentlichungstag und Bekanntmachung des Hinweises auf die Patenterteilung: **25.05.2005**
(21) Anmeldenummer: 02020614.0
(22) Anmeldetag: 13.09.2002
(51) Int. Cl.: H05K 7/02, H01R 13/115, H01R 9/22

(54) **Stanzgitter mit einem Anschlusskontakt und Messeraufnahmekontakt**
Stamped grid with connecting contact for co-operation with blade
Grille estampée avec contact de connexion pour recevoir une lame

(30) Priorität: 08.10.2001 DE 10149574
(43) Veröffentlichungstag der Anmeldung: 09.04.2003
(73) Patentinhaber: Neumann-Henneberg, Wolf, 78604 Rietheim-Weilheim (DE)
(72) Erfinder: Neumann-Henneberg, Wolf, 78604 Rietheim-Weilheim (DE)
(74) Vertreter: Späth, Dieter, Dipl.-Ing.

(56) Entgegenhaltungen:
- EP-A- 0 240 453
- EP-A- 1 018 783
- DE-A- 3 928 751
- US-A- 6 094 811

## Beschreibung

Die Erfindung betrifft ein Stanzgitter mit einem Anschlusskontakt gemäß dem Oberbegriff des Anspruchs 1 sowie einen Messeraufnahmekontakt gemäß dem Oberbegriff des Anspruchs 7.

Stanzgitter sind für Zentralelektriken von Kraftfahrzeugen bekannt. Beispielhaft wird verwiesen auf die DE 197 13 008 C1. Zur Ausbildung von Messerkontakten als Anschlusskontakten werden Enden von Stegleitern des Stanzgitters rechtwinklig vom Stanzgitter abstehend umgebogen. Zur Ausbildung von Messeraufnahmekontakten als Anschlusskontakte wird beim Stanzen des Stanzgitters ein Spalt in die jeweiligen Enden der Stegleiter gestanzt, bevor diese rechtwinklig abstehend umgebogen werden. Zur Ausbildung der Messeraufnahmekontakte können die Enden der Stegleiter verbreitert sein. Die Messerkontakte und Messeraufnahmekontakte dienen zum elektrischen Anschluss von Sicherungen, Relais und sonstigen elektrischen oder elektronischen Bauteilen, die einen Messeraufnahmekontakt oder einen Messerkontakt aufweisen. Die Kontakte der Bauelemente werden in bzw. auf die Anschlusskontakte des Stanzgitters gesteckt.

Nachteil des bekannten Stanzgitters ist, dass es aus einem Blech gestanzt werden muss, das eine ausreichende Federelastizität und insbesondere keine Relaxationserscheinungen aufweist. Insbesondere das Problem der Relaxation erfordert ein vergleichsweise teures Blech, wenn das Stanzgitter im Betrieb erhöhten Temperaturen von beispielsweise 135°C, 560°C, 200°C und mehr ausgesetzt ist. Weiterer Nachteil ist der erhöhte Herstellungsaufwand des Stanzgitters durch das Biegen der Anschlusskontakte.

Ein weiteres Stanzgitter mit Messeraufnahmekontakten ist bekannt aus der EP-A-1 018 783 die als nächstliegender Stand der Technik betrachtet wird. Die Messeraufnahmekontakte dieses Stanzgitters sind separat hergestellt und durch Nieten mit Stegleitern des Stanzgitters verbunden. Das Verbinden der Messeraufnahmekontakte mit dem Stanzgitter ist aufwendig.

Der Erfindung liegt die Aufgabe zugrunde, ein Stanzgitter mit Messeraufnahmekontakten vorzuschlagen, dessen Stegleiter aus preisgünstigem Material herstellbar sind und dessen Messeraufnahmekontakte trotzdem gute Federeigenschaften und eine hohe Kontaktanpresskraft aufweisen. Weitere Aufgabe der Erfindung ist es, einen Messeraufnahmekontakt für ein derartiges Stanzgitter vorzuschlagen.

Diese Aufgabe wird erfindungsgemäß durch die Merkmale der Ansprüche 1 oder 7 gelöst. Beim erfindungsgemäßen Stanzgitter mit den Merkmalen des Anspruchs 1 ist der Anschlusskontakt ein Messeraufnahmekontakt, der als separates Teil hergestellt und mit dem Stegleiter verbunden ist. Die Erfindung ermöglicht die Herstellung des Anschlusskontakts aus einem anderen Material als das Stanzgitter. Das Stanzgitter selbst kann beispielsweise aus einem preisgünstigen und gut stanzbaren Blech bestehen. Für den Anschlusskontakt wird ein Blech oder sonstiger Werkstoff mit beispielsweise guten Federeigenschaften verwendet. Ist das Stanzgitter im Betrieb erhöhten Temperaturen ausgesetzt, wird für den Anschlusskontakt ein Werkstoff gewählt, der bei den erhöhten Betriebstemperaturen keine Relaxationserscheinungen zeigt, jedenfalls wenn die Federelastizität eine wesentliche und notwendige Eigenschaft des Anschlusskontakts ist. Weiterer Vorteil der Erfindung ist, dass das Stanzgitter zur Ausbildung der Anschlusskontakte nicht gebogen werden muss, wodurch der Herstellungsschritt des Biegens des Stanzgitters entfallen kann. Das Material für das Stanzgitter kann unter dem Gesichtspunkt einer guten elektrischen Leitfähigkeit und guter Stanzeigenschaften ausgewählt werden. Da Federeigenschaften vom Stanzgitter nicht gefordert sind, brauchen diese bei der Materialwahl für das Stanzgitter nicht berücksichtigt werden. Die Auswahl des Materials für den Anschlusskontakt kann unter dem Gesichtspunkt der Federeigenschaften und der Relaxation ggf. bei erhöhter Betriebstemperatur erfolgen.

Des Weiteren sieht die Erfindung vor, den Messeraufnahmekontakt des Stanzgitters mit zwei Kontaktfedern auszubilden, die einen Spalt zum Einstecken eines Messerkontakts zwischen sich aufweisen. In einem Fußbereich sind die beiden Kontaktfedern einstückig miteinander. Der Messeraufnahmekontakt ist beispielsweise als Stanzteil aus Blech hergestellt. Der Messeraufnahmekontakt ist mit Abstand von freien Enden der Kontaktfedern und vom Fußbereich so mit dem Stanzgitter verbunden, dass für jede Kontaktfeder ein Hebelarm entsteht, mit dem das Stanzgitter am Messeraufnahmekontakt angreift. Das Stanzgitter kann zwischen dem Fußbereich und den freien Enden der Kontaktfedern an diesen angreifen, so dass ein Teil einer Länge der Kontaktfedern die Hebelarme bildet, mit denen das Stanzgitter an den Kontaktfedern angreift. Die Kontaktfedern können auch mit ihnen einstückige Fortsätze aufweisen, die die Kontaktfedern über den Fußbereich hinweg verlängern und die die Hebelarme bilden, mit denen das Stanzgitter an den Kontaktfedern angreift. In beiden Fällen erhöht das Stanzgitter, mit dem der Messeraufnahmekontakt verbunden ist, eine Federsteifigkeit der Kontaktfedern und wirkt ein Relaxation der Kontaktfedern entgegen. Ein mechanischer Halt und ein elektrischer Anschluss eines eingesteckten Messerkontaktes sind verbessert. Das Stanzgitter stützt die Kontaktfedern beim Auseinanderfedern beim Einstecken eines Messerkontakts ab.

Die Verbindung des Anschlusskontakts mit dem Stanzgitter ist insbesondere eine Steckverbindung und/oder eine stoffschlüssige Verbindung. Zum Herstellen der Steckverbindung wird der Anschlusskontakt vorzugsweise in das Stanzgitter ein- oder aufgepresst, damit die Verbindung eine ausreichend hohe mechanische Festigkeit aufweist. Eine stoffschlüssige Verbindung erfolgt insbesondere durch Schweißen, wobei ein bevorzugtes Schweißverfahren ein Ultraschallschweißen ist.

Eine Weiterbildung der Erfindung sieht vor, dass die Verbindung des Messeraufnahmekontakts mit dem Stanzgitter die Kontaktfedern zusammendrückt und den Spalt zwischen den Kontaktfedern verengt. Dadurch wird eine Kontaktanpresskraft (Kontaktnormalkraft) erhöht. Weiterer Vorteil ist, dass der Spalt breiter gestanzt werden kann, was das Stanzen vereinfacht oder überhaupt erst ermöglicht.

Um einen mechanischen Halt der Anschlusskontakte zu verbessern sieht eine Ausgestaltung der Erfindung vor, dass die Anschlusskontakte in einem elektrisch isolierenden Rahmen des Stanzgitters aufgenommen sind. Der Rahmen weist zu diesem Zweck Aufnahmekammern für die Anschlusskotakte bildende Durchbrüche oder dgl. auf. Der Rahmen besteht insbesondere aus Kunststoff, mit dem das Stanzgitter umspritzt oder an dem das Stanzgitter in sonstiger Weise angebracht ist.

Für größere Stromstärken sieht eine Ausgestaltung der Erfindung vor, zwei oder mehr Messeraufnahmekontakte nebeneinander so anzuordnen, dass ihre Spalte zum Einstecken eines Messerkontakts fluchten. Mit Fluchten ist gemeint, dass die Spalte der nebeneinander angeordneten Messeraufnahmekontakte so angeordnet und ausgerichtet sind, dass ein Messerkontakt in die zwei oder mehr Messeraufnahmekontakte gesteckt werden kann.

Die Ansprüche 7 und 8 sind auf Messeraufnahmekontakte für ein Stanzgitter gerichtet, wie sie vorstehend erläutert worden sind.

Die Erfindung wird nachfolgend anhand in der Zeichnung dargestellter Ausführungsbeispiele näher erläutert. Es zeigen:
- Figur 1: einen Messerkontakt
- Figur 2: zwei Ausführungsbeispiele erfindungsgemäßer Anschlusskontakte für ein Stanzgitter;
- Figur 3: ein Stanzgitter mit Anschlusskontakten gemäß der Erfindung in perspektivischer Darstellung, wobei das Stanzgitter zum Zwecke der klaren Darstellung vereinfacht ist; und
- Figur 4: das Stanzgitter aus Figur 3 umspritzt mit einem Rahmen aus Kunststoff.

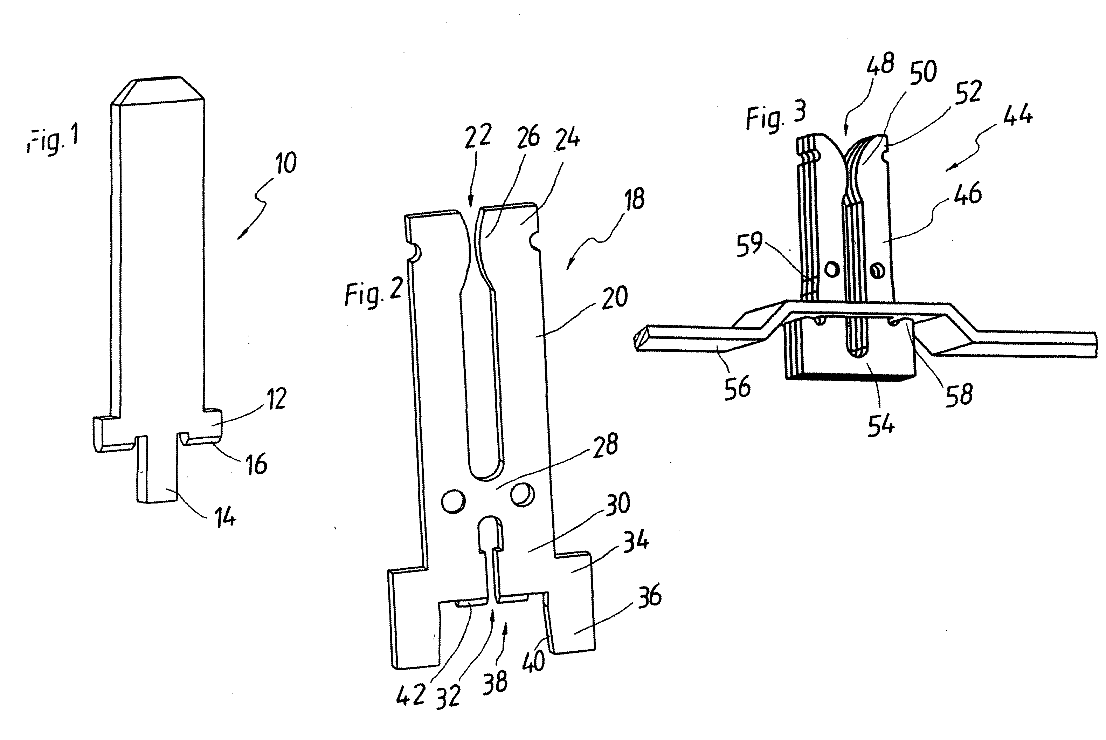

Der in Figur 2 dargestellte Anschlusskontakt ist als Messeraufnahmekontakt 18 ausgebildet. Er weist zwei Kontaktfedern 20 auf, die die Form flacher Leisten aufweisen und in einer gemeinsamen Ebene parallel nebeneinander angeordnet sind. Die beiden Kontaktfedern 20 begrenzen einen Spalt 22 zwischen sich, der an freien Enden 24 der Kontaktfedern 20 offen ist. Der Spalt 22 dient in an sich bekannter Weise zum Einstecken eines Messerkontakts. Zur besseren Kontaktierung sind einander zugewandte Ränder der Kontaktfedern 20 im Mündungsbereich des Spaltes 22 mit konvexen, einander zugewandten und den Spalt 22 verengenden Wölbungen 26 versehen.

In einem Fußbereich 28 sind die beiden Kontaktfedern 20 einstückig miteinander. Der Messeraufnahmekontakt 18 weist zwei Fortsätze 30 auf, die die Kontaktfedern 20 über den Fußbereich 28 hinweg gerade verlängern. Die beiden Fortsätze 30 sind durch einen Schlitz 32 voneinander getrennt. Jeder Fortsatz 30 bildet einen Hebelarm für eine der beiden Kontaktfedern 20. Durch Auseinanderdrücken der Fortsätze 30 werden die Kontaktfedern 20 zusammengedrückt und der Spalt 22 zwischen den Kontaktfedern 20 verengt sich. Die Fortsätze 30 weisen eine Z-förmige Abwinklung 34 nach außen auf, wodurch Enden 36 der Fortsätze 30 nach außen versetzt sind. Zwischen den Enden 36 der Fortsätze 30 besteht ein Zwischenraum 38, mit dem der Messeraufnahmekontakt 18 durch Stecken auf das Stanzgitter 56 setzbar ist, wie es in Figur 3 dargestellt ist.

Einander zugewandte Ränder der Enden 36 sind als Schrägflächen 40 ausgebildet, die den Zwischenraum 38 zu dessen freier Seite hin erweitern. Die Schrägflächen 40 vereinfachen das Aufsetzen auf das Stanzgitter 56. Zudem ermöglichen die Schrägflächen 40, eine Breite des Zwischenraums 38 an dessen geschlossener, auf dem Stanzgitter 56 aufsitzender Seite enger als das Stanzgitter 56 an der Aufsetzstelle auszubilden. Dadurch werden beim Stecken des Messeraufnahmekontakts 18 auf das Stanzgitter 56 die Enden 36 der Fortsätze 30 auseinandergedrückt und über die Fortsätze 30 die Kontaktfedern 20 zusammengedrückt und der Spalt 22 zwischen den Kontaktfedern 20 verengt. Auf diese Weise gelingt es, den die Kontaktkraft erzeugenden Spalt 22 des Messeraufnahmekontaktes 18 bei gleichbleibendem Spalt im Stanzwerkzeug an die Materialstärke eines Messerkontaktes in den Spalt 22 einzusteckenden Messerkontaktes anzupassen. Es gelingt einen zum Standard erhobenen Messeraufnahmekontakt an die unterschiedlichen Materialstärken von Messerkontakten anzupassen.

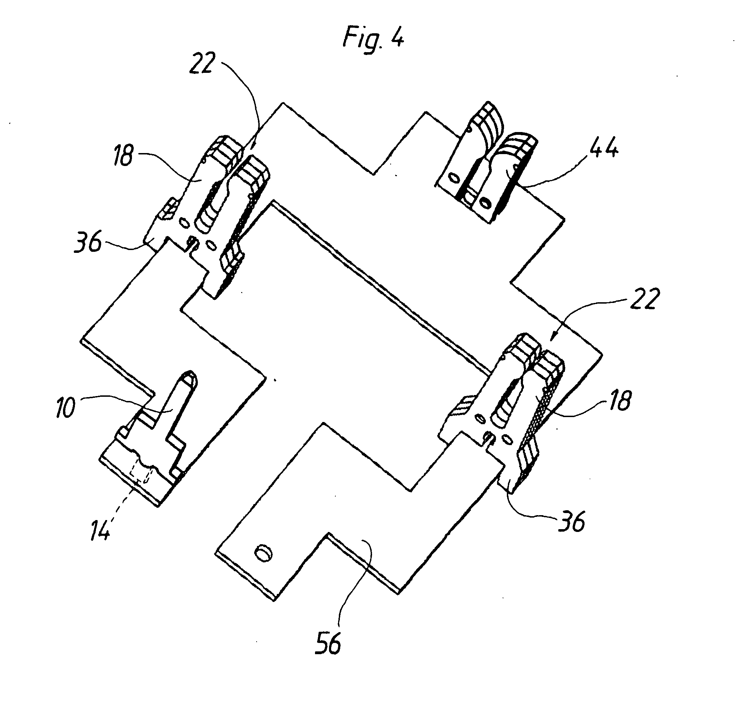

Die Verengung des Spalts 22 zwischen den Kontaktfedern 20 des Messeraufnahmekontakts 18 beim Aufsetzen des Messeraufnahmekontakts 18 auf das Stanzgitter 56 ist in Figur 4 dargestellt: Die in Figur 4 links dargestellten Messeraufnahmekontakte 18 sind am Stanzgitter 56 angesetzt, aber noch nicht vollständig bis zum Aufsitzen von Schweißwarzen 42 der Messeraufnahmekontakte 18 auf das Stanzgitter 56 aufgesetzt. Der Spalt 22 zwischen den Kontaktfedern 20 hat noch seine ursprüngliche Breite. In Figur 4 rechts sind die Messeraufnahmekontakte 18 vollständig auf das Stanzgitter 56 aufgesetzt, die Schweißwarzen 42 sitzen auf dem Stanzgitter 56 auf. Die durch das Aufsetzten der Messeraufnahmekontakte 18 auf das Stanzgitter 56 bewirkte Verengung des Spalts 22 ist unschwer erkennbar.

Zum Verschweißen mit dem Stanzgitter 56 sind Schweißwarzen 42 an dem Rand des Zwischenraums 38 ausgebildet, mit dem der Messeraufnahmekontakt 18 auf das Stanzgitter 56 aufgesetzt wird. Die Verbindung des Messeraufnahmekontakts 18 mit dem Stanzgitter 56 erfolgt vorzugsweise durch Ultraschallschweißung.

Für höhere Strombelastungen können, wie in Figur 4 dargestellt, mehrere Messeraufnahmekontakte 18 deckungsgleich aneinander anliegend auf das Stanzgitter 56 aufgesetzt werden, so dass die Spalte 22 zwischen den Kontaktfedern 20 zum Einstecken eines Messerkontakts miteinander fluchten.

Der Messeraufnahmekontakt 18 ist einstückig durch Stanzen aus einem Blech hergestellt.

Figur 3 zeigt ein zweites Ausführungsbeispiel eines Messeraufnahmekontakts 44 als Anschlusskontakt eines Stanzgitters 56. Dieser Messeraufnahmekontakt 44 weist ebenfalls zwei zueinander parallele Kontaktfedern 46 auf, die einen Spalt 48 zwischen sich begrenzen. Auch die den Spalt 48 verengenden Wölbungen 50 an den freien Enden 52 der Kontaktfedern 46 sind vorhanden. Im Unterschied zu Figur 1 endet der Messeraufnahmekontakt 44 aus Figur 2 allerdings mit dem Fußbereich 54, in dem die Kontaktfedern 46 einstückig miteinander sind.

Zur Verbindung mit dem Stanzgitter 56 wird der Messeraufnahmekontakt 44 mit den freien Enden 52 seiner Kontaktfedern 46 voran durch einen Schlitz des Stanzgitters 56 durchgesteckt. Der Messeraufnahmekontakt 44 weist nach außen stehende Schultern 58 an einander abgewandten Längsaußenrändern der Kontaktfedern 46 auf. Mit den Schultern 58 liegt der Messeraufnahmekontakt 44 am Stanzgitter 56 an. An den Schultern 58 ist der Messeraufnahmekontakt 44 durch Ultraschallschweißung mit dem Stanzgitter 56 verbunden. Zum Schweißen sind die Schultern 58 mit Schweißwarzen ausgebildet, die in der Zeichnung nicht sichtbar sind.

Die Schultern 58 weisen einen Abstand vom Fußbereich 54 des Messeraufnahmekontakts 44 auf, die Schultern 58 sind also im Längsbereich der Kontaktfedern 56 angeordnet. Auf diese Weise sind auch bei dem in Figur 3 dargestellten Messeraufnahmekontakt 44 Hebelarme gebildet, mit denen das Stanzgitter 56 an den Kontaktfedern 46 angreift. Eine Federsteifigkeit der Kontaktfedem 46 wird erhöht und die Kontaktanpresskraft (Kontaktnormalkraft) vergrößert. Durch einen entsprechend kurzen Schlitz im Stanzgitter 56 können die Kontaktfedern 46 des Messeraufnahmekontakts 44 zusammengedrückt und der Spalt 48 verengt werden.

In Figuren 3 und 4 sind für eine höhere Strombelastbarkeit drei Messeraufnahmekontakte 44 deckungsgleich aneinander anliegend durch den Schlitz im Stanzgitter 56 durchgesteckt und mit dem Stanzgitter 56 verschweißt.

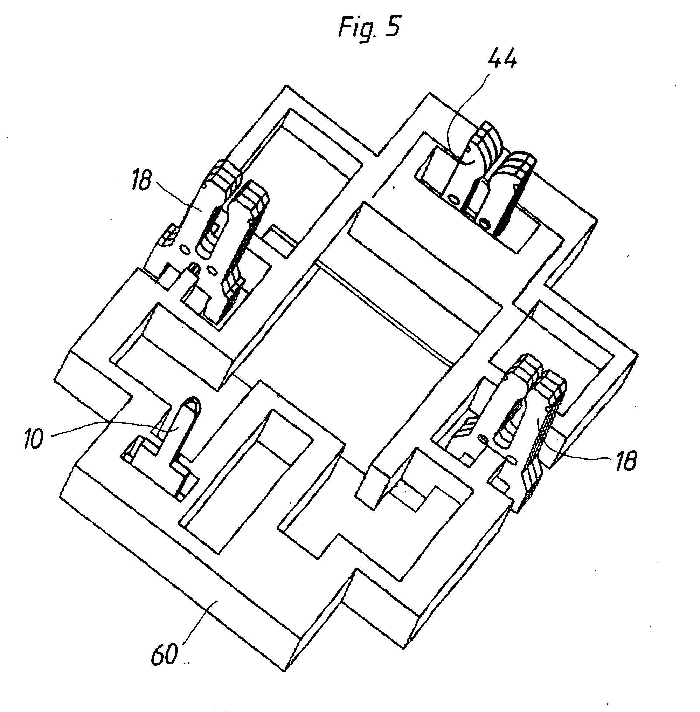

In Figur 5 ist das Stanzgitter 56 aus Figur 3 mit einem Rahmen 60 aus Kunststoff umspritzt. Der Rahmen 60 isoliert das Stanzgitter 56 elektrisch und verbessert einen mechanischen Halt der verschiedenen Anschlusskontakte 10, 18, 44. Der Rahmen 60 kann vor oder nach dem Stecken und Schweißen der Anschlusskontakte 10, 18, 44 gespritzt sein. Wird der Rahmen 60 nach dem Verbinden der Anschlusskontakte 10, 18, 44 mit dem Stanzgitter 56 gespritzt, werden Durchbrüche als Aufnahmekammern für die Anschlusskontakte 10, 18, 44 vorgesehen. Der Rahmen 60 kann auch in anderer Weise als durch Spritzen am Stanzgitter 56 angeordnet werden.

Der Messeraufnahmekontakt 44 weist Schrägflächen 59 an einander abgewandten Längsaußenrändern der Kontaktfedern 46 auf, die das Zusammendrücken der Kontaktfedern 46 bewirken. Der Messeraufnahmekontakt 44 ist einstückig durch Stanzen aus einem Blech hergestellt.

## Patentansprüche

1. Stanzgitter mit einem Anschlusskontakt (18; 44), der zwei Kontaktfedern (20; 46) aufweist, die in einem Fußbereich (28; 54) einstückig miteinander sind, wobei der Anschlusskontakt (18; 44) ein Messeraufnahmekontakt (18; 44) und der Anschlusskontakt (18; 44) ein vom Stanzgitter (56) ursprünglich separates und mit dem Stanzgitter (56) verbundenes Teil ist, **dadurch gekennzeichnet, dass** jede Kontaktfeder (20, 46) unter Bildung eines Hebelarms mit Abstand von freien Enden (24, 52) der Kontaktfedern (20, 46) und vom Fußbereich (28; 54) mit dem Stanzgitter (56) verbunden ist.

2. Stanzgitter nach Anspruch 1, **dadurch gekennzeichnet, dass** das Stanzgitter (56) eine Steckverbindung mit dem Anschlusskontakt (18; 44) aufweist.

3. Stanzgitter nach Anspruch 1 oder 2, **dadurch gekennzeichnet, dass** das Stanzgitter (56) eine stoffschlüssige Verbindung mit dem Anschlusskontakt (18; 44) aufweist.

4. Stanzgitter nach Anspruch 1, **dadurch gekennzeichnet, dass** die Verbindung des Messeraufnahmekontakts (18; 44) mit dem Stanzgitter (56) die Kontaktfedern (20; 46) zusammendrückt.

5. Stanzgitter nach einem der vorhergehenden Ansprüche, **dadurch gekennzeichnet, dass** der Anschlusskontakt (18; 44) in einem elektrisch isolierenden Rahmen (60) des Stanzgitters (56) aufgenommen ist.

6. Stanzgitter nach Anspruch 1, **dadurch gekennzeichnet, dass** zwei oder mehr Messeraufnahmekontakte (18; 44) nebeneinander angeordnet sind, deren Spalte (22; 48) zum Einstecken eines Messerkontakts fluchten.

7. Messeraufnahmekontakt zum Verbinden mit einem Stanzgitter, mit zwei Kontaktfedern, die in einem Fußbereich einstückig miteinander sind, **dadurch gekennzeichnet, dass** der Messeraufnahmekontakt (18; 44) zwei Verbindungsstellen (34, 36, 42; 58) zum Verbinden mit einem Stanzgitter (56) aufweist, die zur Bildung von Hebelarmen für die Kontaktfedern (20; 46) mit Abstand vom Fußbereich (28; 54) und von freien Enden (24; 52) der Kontaktfedern (20; 46) angeordnet sind.

8. Messeraufnahmekontakt nach Anspruch 7, **dadurch gekennzeichnet, dass** der Messeraufnahmekontakt (18; 44) mindestens eine Schrägfläche (40; 59) zum Ausrichten des Messeraufnahmekontakts (18; 44) an einem Stanzgitter (56) beim Stecken des Messeraufnahmekontakts (18; 44) auf/in das Stanzgitter (56) aufweist, die zu einer der beiden Verbindungsstellen (34, 36, 42; 58) des Messeraufnahmekontakts (18; 44) führt.

## Claims

1. Pressed metal grid having a connection contact (18; 44), which includes two contact springs (20; 46), which merge into one piece in a foot region (28; 54), wherein the connection contact (18; 44) is a blade pickup contact (18; 44) and the connection contact (18; 44) is a part which is first separate from the pressed metal grid (56) and is connected to the pressed metal grid (56), **characterised in that** each contact spring (20, 46) is connected to the pressed metal grid (56) thus forming a lever arm with a spacing from the free ends (24, 52) of the contact springs (20, 46) and from the foot region (28; 54).

2. Pressed metal grid according to claim 1, **characterised in that** the pressed metal grid (56) includes a plug-in connection with the connection contact (18; 44).

3. Pressed metal grid according to claim 1 or 2, **characterised in that** the pressed metal grid (56) includes a connection with the connection contact (18; 44) of self-substance.

4. Pressed metal grid according to claim 1, **characterised in that** the connection of the blade pickup contact (18; 44) to the pressed metal grid (56) forces the contact springs (20; 46) together.

5. Pressed metal grid according to one of the previous claims, **characterised in that** the connection contact (18; 44) is accommodated in an electrically insulating frame (60) of the pressed metal grid (56).

6. Pressed metal grid according to claim 1, **characterised in that** two or more blade pickup contacts (18; 44) are disposed adjacent one another, the gaps (22; 48) between which are in alignment for the insertion of a blade contact.

7. Blade pickup contact for connection to a pressed metal grid, having two contact springs, which are together in one piece in a foot region, **characterised in that** for connection to a pressed metal grid (56), the blade pickup contact (18; 44) includes two connecting points (34, 36, 42; 58), which are disposed at a spacing from the foot region (28; 54) and from the free ends (24; 52) of the contact springs (20; 46) for forming lever arms for the contact springs (20; 46).

8. Blade pickup contact according to claim 7, **characterised in that** the blade pickup contact (18; 44) includes at least one inclined face (40; 59) for the alignment of the blade pickup contact (18; 44) to a pressed metal grid (56) when plugging the blade pickup contact (18; 44) onto/into the pressed metal grid (56), said inclined face leading to one of the two connecting points (34, 36, 42; 58) of the blade pickup contact (18; 44).

## Revendications

1. Grille de connexion découpée comprenant un contact de raccordement (18 ; 44) qui présente deux ressorts de contact (20 ; 46) formant un seul tenant dans une zone inférieure (28 ; 54), sachant que le contact de raccordement (18 ; 44) est un contact recevant un sabre (18 ; 44) et le contact de raccordement (18 ; 44) est un élément à l'origine distinct de la grille de connexion découpée (56) et reliée à ladite grille de connexion découpée (56), **caractérisé en ce que** chaque ressort de contact (20, 46) est relié à la grille de connexion découpée (56) à distance des extrémités libres (24, 52) des ressorts de contact (20, 46) et de la zone inférieure (28 ; 54), en formant un bras de levier.

2. Grille de connexion découpée selon la revendication 1, **caractérisée en ce que** la grille de connexion découpée (56) présente une liaison par fiche avec le contact de raccordement (18 ; 44).

3. Grille de connexion découpée selon la revendication 1 ou 2, **caractérisée en ce que** la grille de connexion découpée (56) présente avec le contact de raccordement (18 ; 44) une liaison par union intime de la matière.

4. Grille de connexion découpée selon la revendication 1, **caractérisée en ce que** le fait de relier le contact de raccordement (18 ; 44) à la grille de connexion découpée (56) comprime les ressorts de contact (20 ; 46).

5. Grille de connexion découpée selon l'une des revendications précédentes, **caractérisée en ce que** le contact de raccordement (18 ; 44) est logé dans un cadre (60) isolé électriquement de la grille de connexion découpée (56).

6. Grille de connexion découpée selon la revendication 1, **caractérisée en ce que** deux contacts recevant un sabre (18 ; 44) ou davantage sont placés côte à côte, dont les fentes (22 ; 48) sont en alignement afin d'y loger un contact sabre.

7. Contact recevant un sabre destiné à être relié à une grille de connexion découpée, comprenant deux ressorts de contact qui forment un seul tenant dans une zone inférieure, **caractérisé en ce que** le contact recevant un sabre (18 ; 44) présente deux points de liaison (34, 36, 42 ; 58) pour le relier à une grille de connexion découpée (56), lesquels sont disposés à distance de la zone inférieure (28 ; 54) et d'extrémités libres (24 ; 52) des ressorts de contact (20 ; 46), afin de former des bras de levier pour les ressorts de contact (20 ; 46).

8. Contact recevant un sabre selon la revendication 7, **caractérisé en ce que** le contact recevant un sabre (18 ; 44) présente au moins un chanfrein (40 ; 59) pour positionner ledit contact recevant un sabre (18 ; 44) sur une grille de connexion découpée (56) lors de la mise en place dudit contact recevant un sabre (18 ; 44) sur/dans la grille de connexion découpée (56), lequel chanfrein mène à l'un des deux points de liaison (34, 36, 42 ; 58) du contact recevant un sabre (18 ; 44).
